# EUROPEAN PATENT SPECIFICATION

(11) **EP 0 779 673 B1**
(45) Date of publication and mention of the grant of the patent: **16.10.2002**
(21) Application number: 96120007.8
(22) Date of filing: 12.12.1996
(51) Int. Cl.: H01P 1/387

(54) **Non-reciprocal circuit element**
Nichtreziprokes Schaltungselement
Elément de circuit non-réciproque

(30) Priority: 13.12.1995 JP 32483495; 18.12.1995 JP 32908095; 09.12.1996 JP 32841896
(43) Date of publication of application: 18.06.1997
(73) Proprietor: MURATA MANUFACTURING CO., LTD., Nagaokakyo-shi Kyoto-fu 226 (JP)
(72) Inventor: Hasegawa, Takashi, Nagaokakyo-shi, Kyoto-fu (JP)
(74) Representative: Schoppe, Fritz, Dipl.-Ing.

(56) References cited:
- EP-A- 0 618 636
- EP-A- 0 682 380
- US-A- 3 621 477
- US-A- 4 016 510

## Description

The present invention relates to an isolator, a circulator, or other non-reciprocal circuit element employed as a high-frequency component for a microwave band.

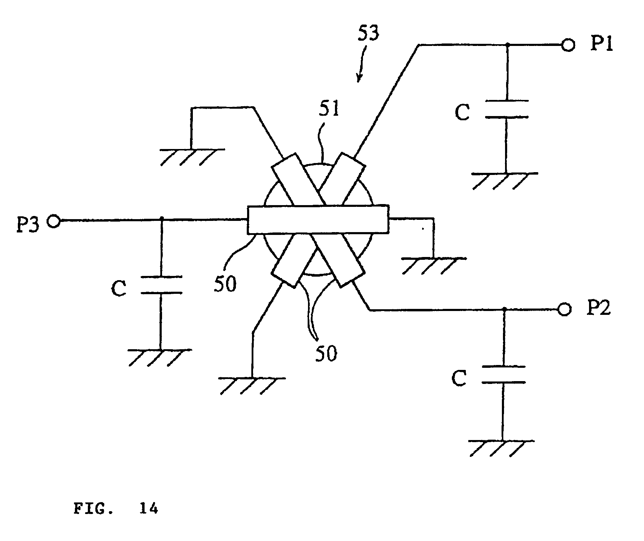

A lumped-constant type isolator or circulator, for example, is characterized in that the attenuation thereof is extremely small in the direction in which signals are transmitted, while it is extremely large in the opposite direction; it is used for a transmitting and receiving circuit or the like of a mobile telephone, a cellular telephone, etc. Fig. 14 shows an equivalent circuit diagram of a typical circulator. A circulator 53 has three central electrodes 50, 50, and 50 which are disposed so that they intersect with each other electrically insulated and at a predetermined angle. Matching capacitors C are connected to respective input/output ports (hereinafter referred to as I/O ports) P1 through P3 on the ends on one side of the respective central electrodes 50, while the ends on the other side thereof are grounded. A ferrite member 51 is placed in contact with the intersecting section of the aforesaid central electrodes 50 so as to apply a DC magnetic field. The isolator has a terminating resistor connected to one of the I/O ports.

The ferrite member 51 employed for the foregoing circulator 53 is required to be rotationally 120-degree symmetrical with respect to the direction in which the DC magnetic field is applied. This is because the use of a ferrite member which is not rotationally 120-degree symmetrical would disturb the balance among the I/O ports P1 through P3 with resultant deterioration in characteristics. From the viewpoints of characteristics, the manufacture of the ferrite member, and the assembly of the circulator, a discoid ferrite member has been used.

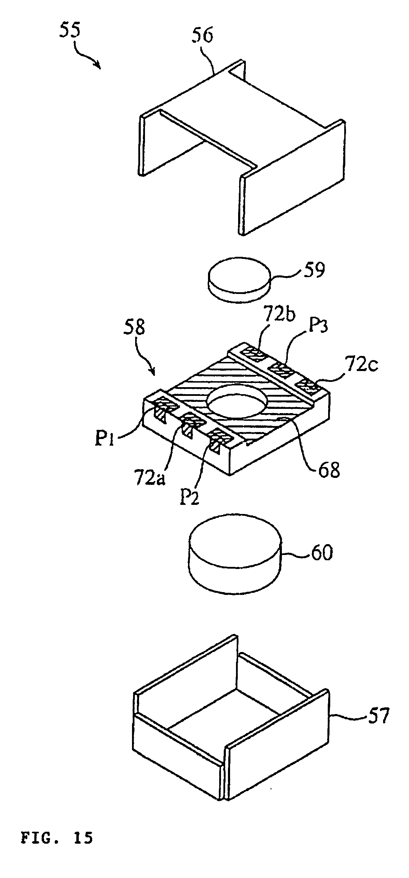

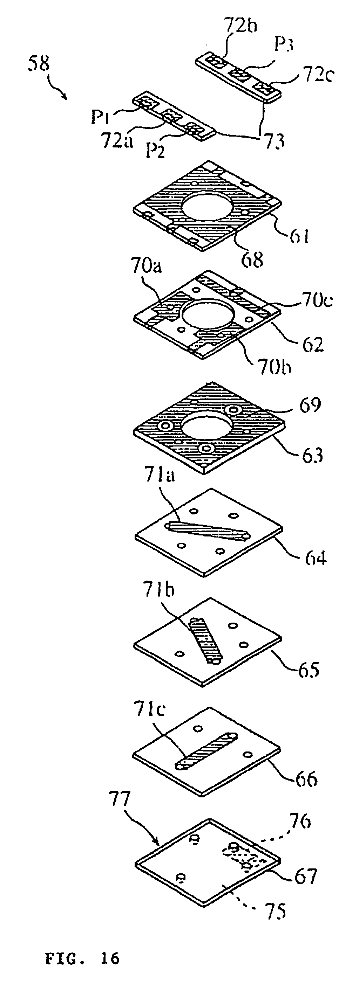

There has been a demand for smaller and cheaper components of the circulators or isolators employed for recent mobile telephones and the like because of the nature of the applications. To respond to such a demand, there have been proposed structures illustrated in Fig. 15 and Fig. 16 which are exploded perspective views observed from bottom. A lumped-constant type circulator 55 has a lower yoke 56, which constitutes a magnetic circuit, and an upper yoke 57 which includes a multilayer-dielectric substrate 58, a ferrite disc 59, and a magnet 60. The dielectric substrate 58 is composed of a plurality of dielectric sheets 61 through 66 which are laminated and formed into one piece; each of the dielectric sheets 61 through 66 has patterned grounding electrodes 68, 69, capacitor electrodes 70a through 70c, and central electrodes 71a through 71c. Disposed on the topmost layer, namely, the dielectric sheet 61, are zonal terminal sheets 73, 73 on which the I/O port terminal electrodes P1 through P3 and grounding terminal electrodes 72a through 72c are formed. To constitute the isolator, a dielectric sheet 77 which has a grounding electrode 75 and a resistance film 76 formed in a pattern is added to the bottommost layer, namely, a dielectric sheet 67 shown in the drawing. The circulator 55 is mounted on a circuit board with the terminal electrodes P1 through P3 facing down.

There have been also proposed such a structure as one in which the aforesaid central electrodes and the matching capacitors are formed into a single unit or one in which the central electrodes and the ferrite disc are formed into a single unit so as to accomplish higher density and fewer components (see Japanese Patent Application No. 4- 125630 and Japanese Patent Application No. 4-208963).

Further, a two-terminal isolator has been disclosed in the laid-open Japanese Patent Application No. 52- 134349.

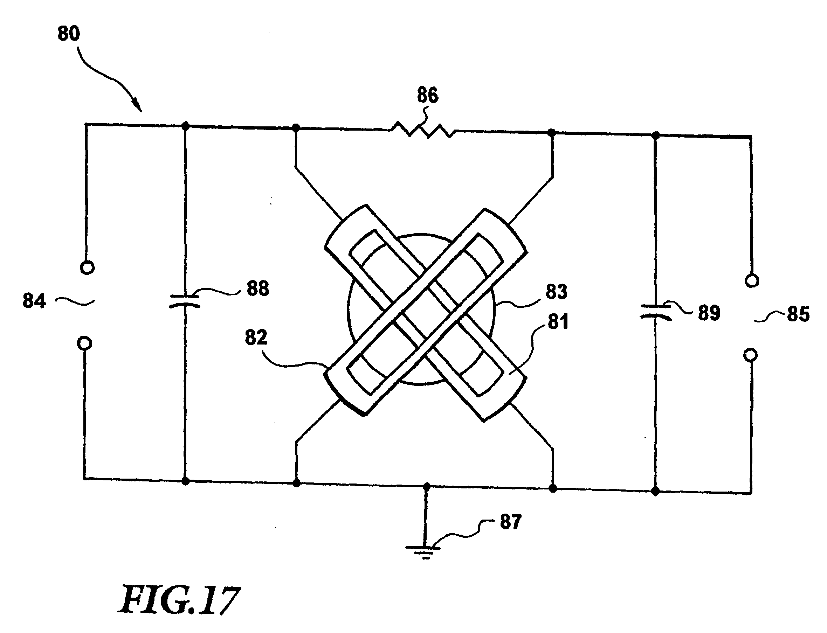

As illustrated in Fig. 17, a two-terminal isolator 80 is constituted by: a central electrode assembly, wherein a first central electrode 81 and a second central electrode 82 are disposed on a ferrite member 83 such that they intersect with each other in an electrically isolated state, a first I/O port 84 and a second I/O port 85 are respectively connected to the ends on one side of the first central electrode 81 and the second central electrode 82, the ends on one side of the first and second central electrodes 81 and 82 are connected through a resistor 86, the ends on the other side of the first and second central electrode 81 and 82 are connected to ground 87, and matching capacitors 88 and 89 are connected in parallel to the first central electrode 81 and the second central electrode 82, respectively; and a magnetic circuit (not shown) for applying a DC magnetic field to the foregoing ferrite member. It has been described in the Japanese Unexamined Patent Publication that such a configuration allows the isolation characteristic to be exhibited over a broader band.

In non-reciprocal circuit elements having the structures shown in Fig. 15 and Fig. 16, there is structural limitation in achieving higher density and a reduced number of components, posing a problem in that further reduction in size and price of the non-reciprocal circuit element cannot be realized. For instance, the foregoing circulator involves forming the dielectric sheets for all central electrodes, securing the areas on the sheets for accommodating the matching capacitors and the terminal electrodes, or forming through-hole electrodes for interconnecting the respective electrodes. This presents a problem in that the component elements inevitably become larger and the cost become higher.

Furthermore, in the two-terminal isolator 80 shown in Fig. 17, if a difference in potential takes place between the first I/O port 84 and the second I/O port 85, then a signal received through the first I/O port is partially attenuated through the resistor connecting the first and second central electrodes 81 and 82, presenting a problem in that the insertion loss characteristic of the two-terminal isolator 80 is deteriorated. Ideally, the potential among the respective I/O ports should be the same in a non-reciprocal circuit element; in an actual use, however, a potential difference occurs among the respective I/O ports due to various factors including the distribution of a magnetic field and the positional relationship between the respective central electrodes and the ferrite member, thus making it difficult to achieve the same potential among the respective I/O ports. Hence, it has not been possible for the two-terminal isolator 80 shown in Fig. 17 to solve the problem of the deterioration in the insertion loss characteristic.

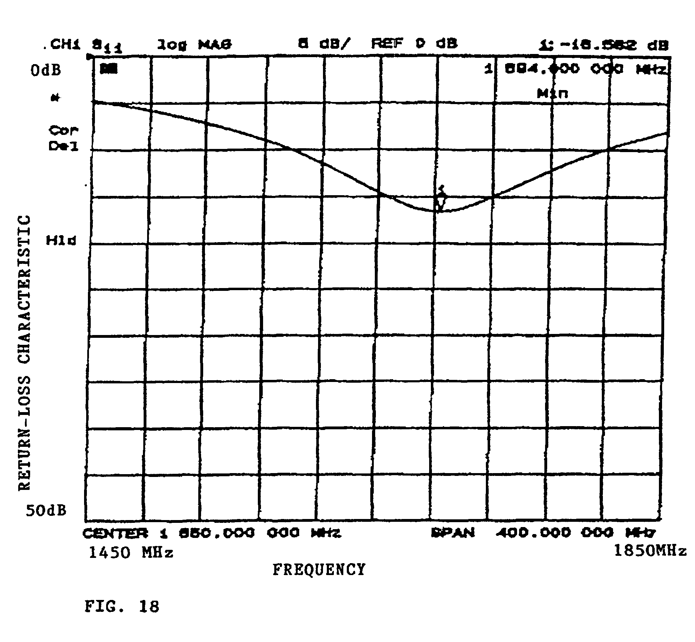

In addition, although the two-terminal isolator 80 shown in Fig. 17 permits the isolation characteristic to be effected over a broader band, it exhibits the return loss characteristic with the same I/O port over a narrow band. Fig. 18 is a chart illustrative of the measurements of the return loss characteristic at the I/O port P1 of the two-terminal isolator 80 shown in Fig. 17.

For example, when the attenuation is 15 dB, a three-terminal isolator shown in Fig. 15 and Fig. 16 provides a 200 MHZ band, whereas the two-terminal isolator shown in Fig. 17 provided only about 80 MHz as it is seen from Fig. 18. Thus, the return loss characteristic in the limited band has been making it difficult for the two-terminal isolator shown in Fig. 17 to achieve matching with electronic circuits or electronic components connected to the input end of the isolator.

US-A-3,6 to 1,477 describe a three-port circulator comprising only two windings crossing each other at right angles so that the number of stray capacitances is reduced and the bandwidth is less restricted. These two windings are each formed by half a turn crossing each other at right angles approximately at the center of a ferrite disc. At one end the two windings are connected through capacitors to connecting terminals and at the other end same are connected to a single conductor following the edge of the ferrite disc. A third connecting terminal is provided and is connected to the conductor.

It is the object of the present invention to provide an improved non-reciprocal circuit element reducing the stray capacitances and thus reducing restrictions of the bandwidth of the circulator due to such stray capacitances.

This object is achieved by a non-reciprocal circuit element according to claim 1.

To this end, according to the present invention, there is provided a non-reciprocal circuit element constituted by: a central electrode assembly composed of first and second central electrodes which are disposed on a ferrite member in such a manner that they intersect with each other in an electrically insulated state and which has first and second I/O ports respectively connected to the ends on one side of the first and second central electrodes, and a third I/O port connected to the ends on the other side thereof; and a magnetic circuit for applying a DC magnetic field to the ferrite member.

Further, a matching circuit configured by connecting a capacitor between the first and second I/O ports and the third I/O port is added.

In a preferred form, a terminating resistor is connected to any one of the I/O ports.

In a further preferred form, either the first or the second I/O port is grounded, and a resistance which is approximately equal to a terminal impedance is connected in parallel between the remaining I/O port and the third I/O port.

In yet another preferred form, the foregoing central electrode assembly is composed of the insulating sheets and the central electrodes which are laminated so that they are alternately stacked with the insulating sheets interleaved between the central electrodes, thereby constituting a laminated body.

In a further preferred form, the respective I/O port electrodes to which the respective central electrodes are connected are formed on the outer surface of the laminated body.

In a still further preferred form, the foregoing insulating sheets are composed of ferrite.
- Fig. 1: is an exploded perspective view illustrating a circulator according to an embodiment described in Claims 1, 5, and 6 of the present invention.
- Fig. 2: is an exploded perspective view of a dielectric substrate of the foregoing circulator.
- Fig. 3: is an equivalent circuit diagram of the foregoing circulator.
- Fig. 4: is a perspective view of a circulator which has been made to verify an advantage of the aforesaid embodiment.
- Fig. 5: shows characteristic curves illustrating the advantage of the aforesaid circulator.
- Fig. 6: is an exploded perspective view illustrating a circulator according to an embodiment of the present invention described in Claim 2.
- Fig. 7: is an equivalent circuit diagram illustrating the foregoing circulator.
- Fig. 8: is a perspective view of a circulator which has been created to check the advantage of the foregoing embodiment.
- Fig. 9: show characteristic curves illustrative of the advantage of the foregoing circulator.
- Fig. 10: is an exploded perspective view illustrative of an isolator according to an embodiment according to the present invention described in Claim 3.
- Fig. 11: is an equivalent circuit diagram illustrative of an isolator according to an embodiment of the present invention described in Claim 4.
- Fig. 12: show characteristic curves illustrative of the advantage of the foregoing isolator.
- Fig. 13: is a return loss characteristic chart illustrative of the advantage of the foregoing isolator.
- Fig. 14: is an equivalent circuit diagram of a conventional circulator.
- Fig. 15: is an exploded perspective view of a conventional circulator.
- Fig. 16: is an exploded perspective view of a conventional dielectric substrate.
- Fig. 17: is a partially schematic diagram of a conventional two-terminal isolator.
- Fig. 18: is a return loss characteristic chart of the foregoing isolator.

Embodiments in accordance with the present invention will now be described in conjunction with the accompanying drawings.

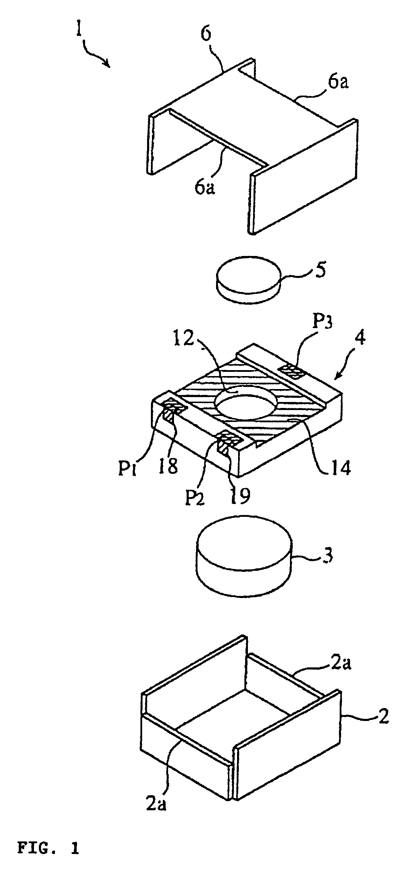

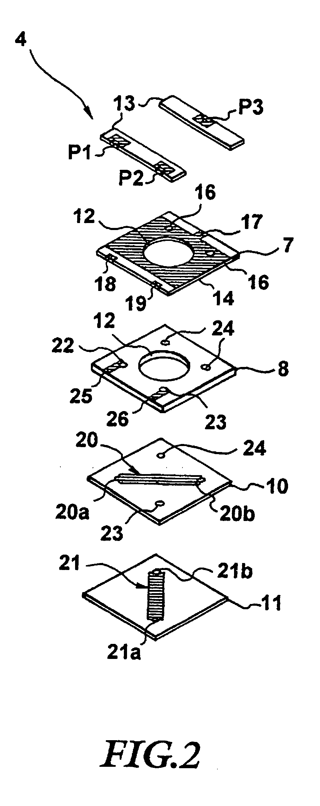

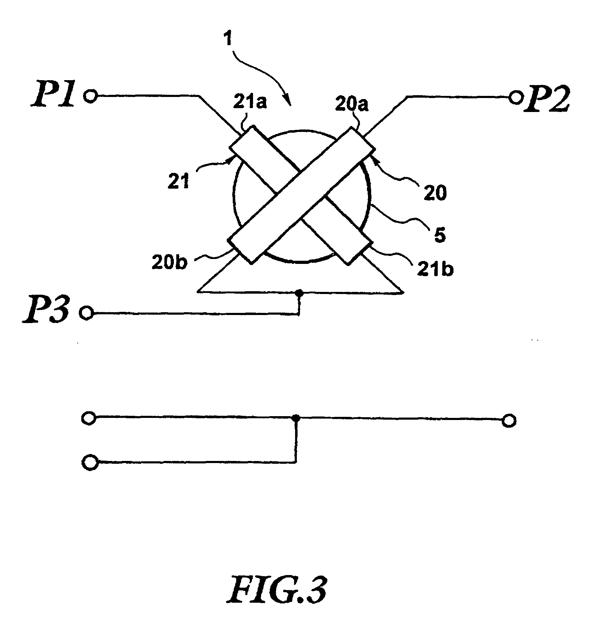

Fig. 1 through Fig. 3 illustrate a circulator according to an embodiment of the present invention; Fig. 1 and Fig. 2 are exploded perspective views and Fig. 3 is an equivalent circuit diagram of the circulator. Fig. 1 and Fig. 2 are the views of the circulator observed from below.

A lumped-constant circulator 1 shown in Fig. 1 is constructed by: a permanent magnet 3 disposed in a box-shaped upper yoke 2 composed of magnetic metal constituting a magnetic circuit; a dielectric multilayer substrate 4 serving as a central electrode assembly, and a discoid ferrite member 5 which is provided above the permanent magnet 3; and a cap-like lower yoke 6 which is also composed of magnetic metal as is the case with the upper yoke 2 and which is attached to the upper yoke 2. A DC magnetic field is applied to the ferrite member 5 by the permanent magnet 3.

The dielectric substrate 4 is constituted by first through fifth dielectric sheets 7 through 10, each sheet measuring approximately 50 µm thick. The top surface of each sheet is provided with a predetermined electrode to be described later which is printed and patterned by vapor deposition. These dielectric sheets 7 through 10 are laminated and contact-bonded, then the resulting laminated assembly is sintered into one piece. The first and second dielectric sheets 7 and 8 are provided with holes 12 and 12, in which the ferrite member 5 is inserted, at the centers thereof.

Zonal terminal strips 13 and 13 are disposed on two edges of the first dielectric sheet 7; each strip 13 is formed by being sintered integrally with the laminated assembly. Formed on the two strips 13 are first through third I/O port electrodes P1 through P3 which are exposed outside through openings 6a and 6a which are formed in the lower yoke 6. The respective port electrodes P1 through P3 are surface-mounted on an electrode line of an external circuit board which is not shown.

A connection electrode 14 is formed on the top surface of the first dielectric sheet 7 and the connection electrode 14 is connected to the I/O electrode P3 via a side electrode 17. Formed on the top surface of the second dielectric sheet 8 shown in the drawing are two connection electrodes 25 and 26 located with the inserting hole 12 therebetween; the connection electrodes 25 and 26 are respectively connected to the remaining I/O port electrodes P1 and P2 via side electrodes 18 and 19.

Zonal central electrodes 20 and 21 are respectively formed on the surfaces of the third and fourth dielectric sheets 10 and 11; the two central electrodes 20 and 21 are arranged so that they are electrically isolated and shifted 90 degrees with respect to each other. Ends 20a and 21a on one side of the respective central electrodes 20 and 21 are connected to the I/O port electrodes P2 and P1 via through-hole electrodes 22 and 23, respectively. Ends 20b and 21b on the other side of the central electrodes 20 and 21 are respectively connected to the connection electrode 14 and the I/O port electrode P3 via a through-hole electrode 24 and the through-hole electrode 16. The connection electrode 14 may be connected to the lower yoke 6; however, the lower yoke is not connected to an electrode line of an external circuit board, which is not shown, when mounting it on the external circuit board. When the connection electrode 14 is not connected to the lower yoke 6, it is conceivable to provide an additional dielectric sheet, on which a resist film is to be formed, between the first dielectric sheet 7 and the terminal strips 13.

The lumped-constant circulator 1 makes use of the non-reciprocal characteristic of the ferrite member 5 in which the phase of dielectric electromotive force differs depending on whether the currents are flowing from the port P1 to the port P2 or from the port P2 to the port P1. The difference in the phase change depends on magnetic force, frequency, and the intersecting angle of the central electrodes 20 and 21. This means that the difference in the phase change can be set to 180 degrees at a design frequency by setting the magnetic force and the intersecting angle of the central electrodes.

The operating principle of the circulator 1 will now be described with reference to Fig. 3.

It is assumed that an electric current which is equal to an input flows from the first I/O port P1 to the third I/O port P3, causing a potential, which is equal to the input in magnitude and nearly equal to the input in phase, to be generated between P3 and P2. It is also assumed that an electric current which is equal to the input flows from the second I/O port P2 to the third I/O port P3, causing a potential, which is nearly equal to the input in magnitude but reversed 180 degrees in phase, to be generated between P3 and P2.

When a signal is supplied through P1, almost all currents from P1 flow into P2 and substantially no currents flow into P3. At this time, the currents flowing from P1 to P3 generate a potential, which has nearly the same phase as that of an input power, between P3 and P2. Currents flowing from P3 to P2 generate a potential of nearly the opposite phase between P1 and P3. This places P1 and P2 at the same potential and the potential at P3 is always approximated to zero volt. Hence, the signal applied to P1 is output to P2 without being transmitted to P3.

On the other hand, when a signal is supplied through P2, nearly all currents supplied through P2 flow into P3 and substantially no currents flow into P1. At this time, only a small potential difference takes place between P2 and P3, meaning that P2 and P3 share nearly the same potential. Currents flowing from P2 to P3 generate a potential of approximately the opposite phase from that of the input power between P3 and P1; therefore, the potential at P1 is always approximated to zero volt. Hence, the signal applied to P2 is output to P3 without being transmitted to P1.

Thus, according to the embodiment, the two central' electrodes 20 and 21 are so arranged that they intersect with each other, and the I/O ports P1 and P2 are respectively connected to the ends on one side of the two central electrodes 20 and 21 and the remaining I/O port P3 is connected to the ends on the other side thereof. This structure makes it possible to reduce the numbers of the central electrodes, capacitors, and I/O terminal electrodes in comparison with the conventional structure. As a result, one layer of dielectric sheet can be deleted, permitting a smaller sheet area because of the capacitor electrode and terminal electrodes which used to be required for the layer can be accordingly omitted. Furthermore, the number of machining steps for the through-hole electrodes can also be reduced, so that the demand for a smaller size and lower price can be fulfilled.

Moreover, since this embodiment has two central electrodes 20 and 21, the ferrite member can be shaped to be 180-degree rotationally symmetrical in relation to the direction in which the DC magnetic field is applied. This allows the ferrite member to be shaped to a cube or any other desired shape and consequently permits lower component costs without sacrificing the non-reciprocal characteristics.

In the embodiment described above, the central electrodes are formed on the dielectric sheets and the ferrite member is brought in contact therewith; in this invention however, the central electrodes may be formed in the ferrite member as an alternative. In this case, a plurality of ferrite sheets are formed and the central electrodes are formed by patterning them thereon, then the ferrite sheets are stacked and contact-bonded to produce a laminated body. This configuration enables further reduced size and lower price. In addition, since the ferrite member can be designed to have a desired shape, more pieces can be punched out from a mother ferrite sheet, thus leading to a higher yield with a resultant lower price. Moreover, the holes 12 for inserting the ferrite member of the first and second dielectric sheets 7 and 8 can be eliminated.

An experiment which has been carried out to verify the advantage of the present invention will now be described.

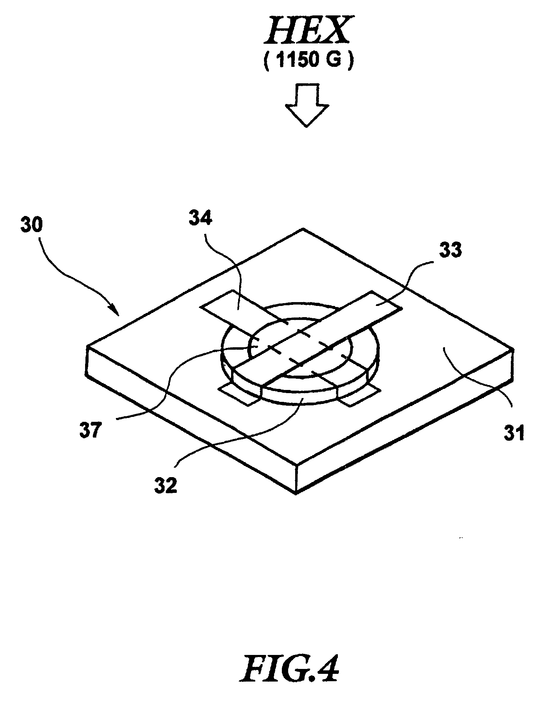

In this experiment, as shown in Table 1 and Fig. 4, a circulator has been made in accordance with the present invention and the insertion loss characteristic and the isolation characteristic of the circulator were measured. Table 1 below shows the dimensions of the respective components making up the circulator and the experimental conditions.

**Table 1**

| Experimental Condition | | |
|---|---|---|
| Ferrite Member | 4 πMs | 800 G |
| | Size | φ3.0mm x t0.3 mm |
| Central Electrode | Line Width | 0.4 mm |
| | Lie Length | 3.0 mm |
| Magnetic Circuit | External Magnetic Field | 1150 G |

In a circulator 30 used in this experiment, a ferrite member 32 was disposed on a copper plate 31 and central electrodes 33 and 34 composed of two copper strips were placed on the top surface of the ferrite member 32 with an insulating tape 37 interleaved between them so that they intersect at an angle of 90 degrees with respect to each other, and the ends on one side thereof were connected to the copper plate 31. The equivalent circuit of the circulator 30 was identical to that shown in Fig. 3. An external magnetic field Hex was applied to the ferrite member 32 by an electromagnet. In the experiment, the measurement was performed on the transmitting characteristic between the port P1 and the port P3; the central electrode 34 served as the port P1, while the copper plate 31 served as the port P3.

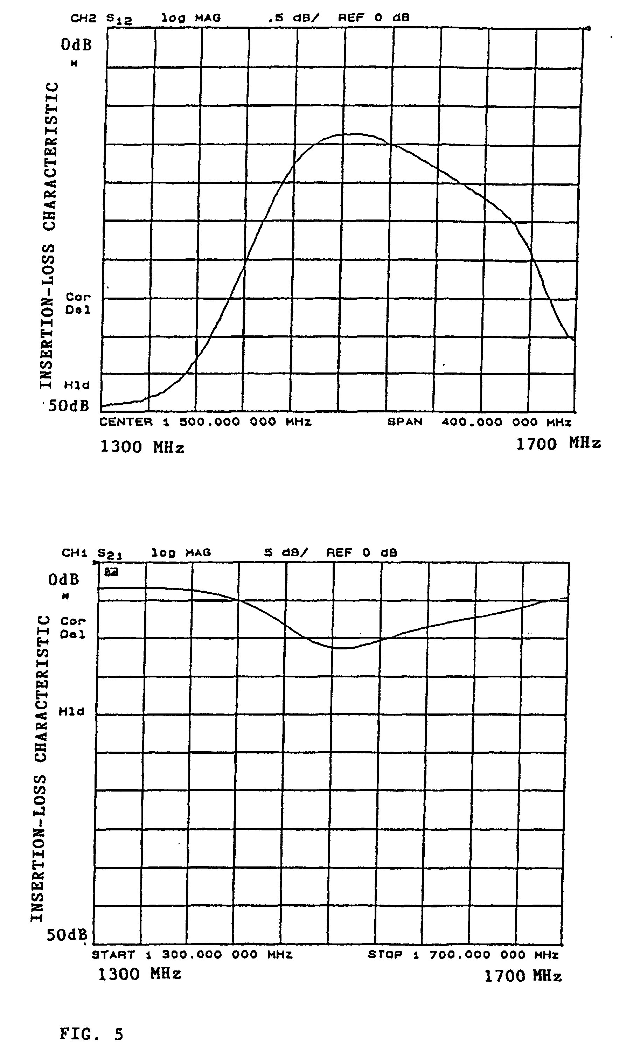

Fig. 5A shows the measurement result of the insertion loss characteristic of the circulator 30; and Fig. 5B shows the measurement result of the isolation characteristic. As it is obvious from the characteristic curves, the circulator 30 has exhibited satisfactory values in both insertion loss characteristic, which represents the signal transmission loss characteristic, and isolation characteristic which represents the attenuation in the opposite direction.

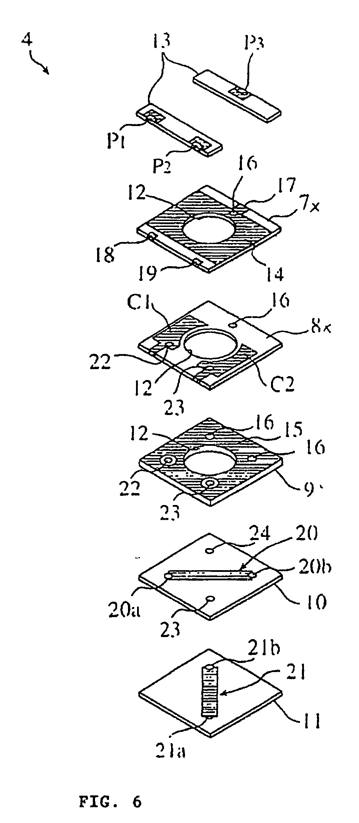

Fig. 6 is a diagram which illustrates a circulator in accordance with an embodiment of the present invention described in Claim 2. Like reference numerals in the drawing as those shown in Fig. 2 denote like or corresponding components. The circulator shares the same basic structure as that shown in Fig. 2; therefore, only different section, namely, a dielectric multilayer substrate 4x will be described.

The foregoing dielectric substrate 4x is constituted by first through fifth dielectric sheets 7x through 11x, each sheet measuring approximately 50 µm thick; the top surface of each sheet is provided with a predetermined electrode to be described later which is printed and patterned by vapor deposition. These dielectric sheets 7x through 11x are laminated and contact-bonded, then the resulting laminated assembly is sintered as one piece. The first through third dielectric sheets 7x to 9x are provided with holes 12, 12, and 12, in which the ferrite member 5 is inserted, at the centers thereof.

Zonal terminal strips 13 and 13 are disposed on two edges of the first dielectric sheet 7x; each strip 13 is formed by being sintered integrally with the laminated assembly. Formed on the two sheets 13 are the first through third I/O port electrodes P1 through P3 which are exposed outside through openings 2a and 6a which are formed in the upper yoke 2 and the lower yoke 6, respectively. The respective port electrodes P1 through P3 are surface-mounted on an electrode line of an external circuit board which is not shown.

A capacitor electrode 14 and a capacitor electrode 15 are formed on the top surfaces of the first dielectric sheet 7x and the third dielectric sheet 9x, respectively; the respective capacitor electrodes 14 and 15 are connected to the I/O port electrode P3 via a plurality of through-hole electrodes 16 and a side electrode 17. Capacitances are generated between the capacitor electrode 14 and C1, C2 and between the capacitor electrode 15 and C1, C2. Formed on the top surface of the second dielectric sheet 8x shown in the drawing are two capacitor electrodes C1 and C2 which surround the inserting holes 12; the two capacitor electrodes C1 and C2 are respectively connected to the remaining I/O port electrodes P1 and P2 via side electrodes 18 and 19.

Zonal central electrodes 20 and 21 are respectively formed on the surfaces of the fourth and fifth dielectric sheets 10 and 11; the two central electrodes 20 and 21 are arranged so that they are electrically isolated and shifted 90 degrees with respect to each other. Ends 20a and 21a on one side of the respective central electrodes 20 and 21 are connected to the I/O port electrodes P2 and P1 via through-hole electrodes 22 and 23, respectively. Ends 20b and 21b on the other side of the central electrodes 20 and 21 are respectively connected to the capacitor electrodes 15, 14x, and the I/O port electrode P3 via a through-hole electrode 24 and the through-hole electrode 16, respectively. The capacitor electrodes C2 and C1 are connected between the ends 20a, 21a on one side and the ends 21b, 20b on the other side.

Such a lumped-constant circulator allows the difference in the phase change to be set to 180 degrees at a design frequency by setting the magnetic force and the intersecting angle of the central electrodes as is the case with the circulator shown in Fig. 2 described above.

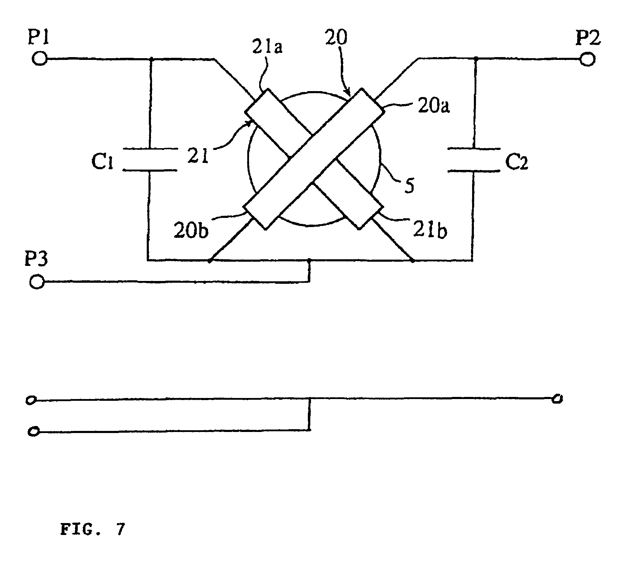

The foregoing circulator will now be described in conjunction with Fig. 7 which is an equivalent circuit diagram of the circulator. As illustrated in Fig. 7, matching capacitors C1 and C2 are connected in parallel between the first I/O port P1 and the third I/O port P3, and between the second I/O port P2 and the third I/O port P3, thereby permitting the matching between the circulator and the electronic circuits and electronic components connecting the circulator at a design frequency.

Thus, as is the case with the circulator shown in Fig. 2, this embodiment also makes it possible to reduce the number of the central electrodes, capacitors, and I/O terminal electrodes in comparison with the conventional structure. The laminated dielectric substrate becomes higher than that in the structure illustrated in Fig. 2 because of the additional dielectric sheet forming the capacitor electrode; however, the height is only about 50 µm and the height of the circulator will not be increased much.

As is the case with the circulator shown in Fig. 2, in the above embodiment also, the central electrodes are formed on the dielectric sheet and brought in contact with the ferrite member; however, the central electrodes may alternatively be formed in the ferrite member. Such a configuration enables further reduced size and lower price as is the case with the circulator shown in Fig. 2. In addition, since the ferrite member can be designed to have a desired shape, more pieces can be punched out from a mother ferrite sheet, thus leading to a higher yield with a resultant lower price.

The ferrite sheet may be used only as the sheet for forming the central electrodes or it may be used as the sheet for forming the capacitor electrodes; the ferrite sheet and the dielectric sheet may be combined in any desired manner.

The following will describe an experiment which has been carried out to verify the advantages of this embodiment.

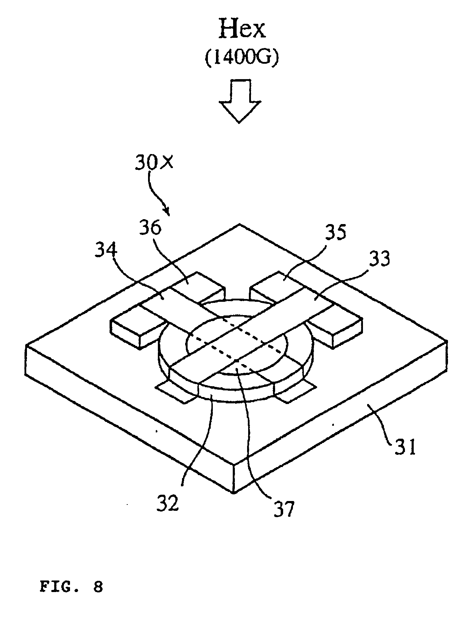

In this experiment, as shown in Table 2 and Fig. 8, a circulator has been made in accordance with the present invention and the insertion loss characteristic and the isolation characteristic of the circulator were measured. Table 2 below shows the dimensions of the respective components making up the circulator and the experimental conditions.

**Table 2**

| Experimental Condition | | |
|---|---|---|
| Ferrite Member | 4 πMs | 800 G |
| | Size | φ3.0 x 0.3 |
| Central Electrode | Line Width | 1.0 mm |
| | Line Length | 3.0 mm |
| Capacitor | Capacitance | 7 pF |
| Magnetic Circuit | External Magnetic Field | 1400 G |

In a circulator 30x used in this experiment, a ferrite member 32 was disposed on a copper plate 31 and central electrodes 33 and 34 composed of two copper strips were placed on the top surface of the ferrite member 32 with an insulating tape 37 interleaved between them so that they intersect at an angle of 90 degrees with respect to each other. Chip capacitors 35 and 36 were respectively connected to the ends on one side of the central electrodes 33 and 34; the ends on the other side thereof were connected to the copper plate 31. The equivalent circuit of the circulator 30 was identical to that shown in Fig. 7. An external magnetic field Hex was applied to the ferrite member 32 by an electromagnet. In the experiment, the measurement was performed on the transmitting characteristic between the port P1 and the port P3; the central electrode 34 served as the port P1 and the copper plate 31 served as the port P3.

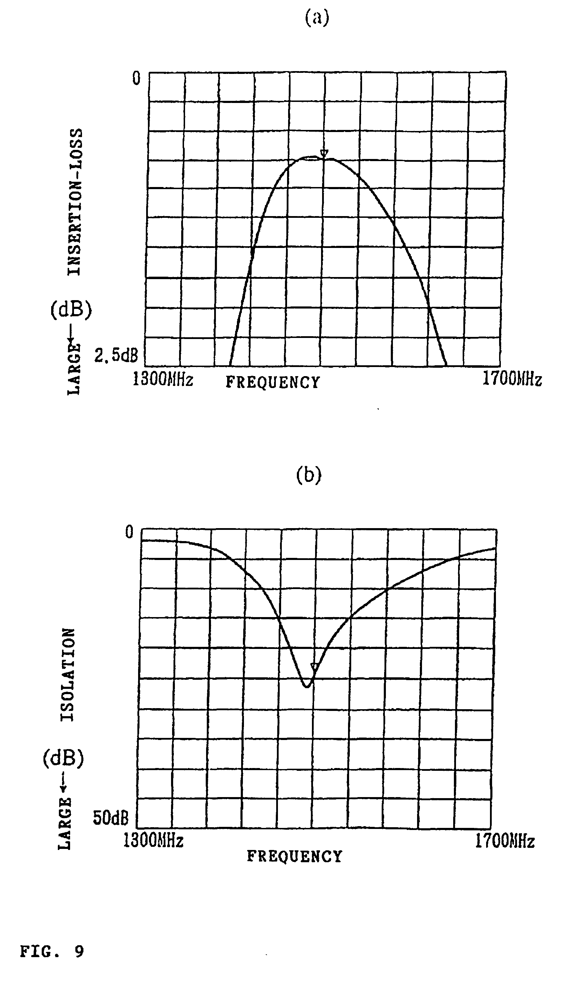

Fig. 9A and Fig. 9B are characteristic charts which show the measurement result of the insertion loss characteristic and the isolation characteristic, respectively. As it is obvious from the characteristic curves, the circulator 30x has exhibited satisfactory values in both insertion loss characteristic, which represents the signal transmission loss characteristic, and isolation characteristic which represents the attenuation in the opposite direction.

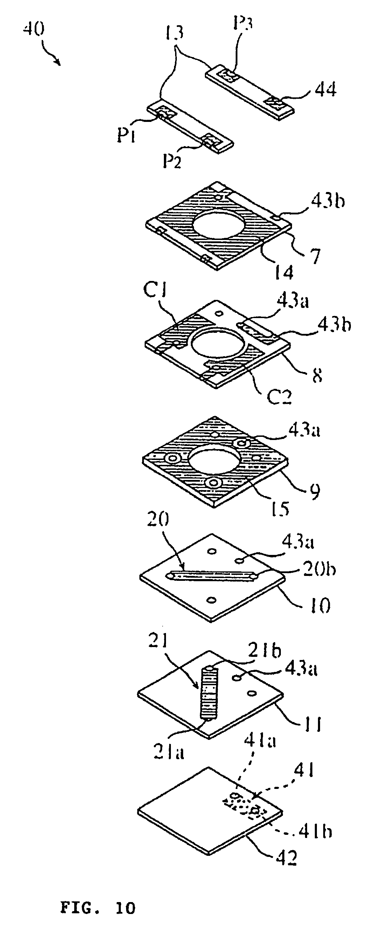

Fig. 10 is a diagram which illustrates an isolator in accordance with an embodiment of the present invention described in Claim 3. Like reference numerals in the drawing as those shown in Fig. 2 and Fig. 6 denote like or corresponding components. The isolator shares the same basic structure as that shown in Fig. 2 and Fig. 6; therefore, only different sections will be described.

An isolator 40 according to this embodiment has a terminating resistance film 41 which is connected to the I/O port P3; the terminating resistance film 41 is formed on a sixth dielectric sheet 42 disposed under the fifth dielectric sheet 11. One end 41a is connected to a GND electrode 44 via through-hole electrodes 43a and a side surface electrode 43b; the other end 41b is connected to the I/O port P3 via the other ends 20b and 21b of the central electrodes 20 and 21 and the capacitor electrodes 15 and 14, respectively. Hence, the isolator 40 according to the embodiment has the structure wherein a resistor has been added to the I/O port P3 of the circulator shown in Fig. 7. Although the resistor has been connected to the I/O port P3 of the circulator illustrated in Fig. 7 in this embodiment, no matching capacitor would be required if matching with an external circuit is made; therefore, the resistor may be connected, for example, to the I/O port P3 of the circulator shown in Fig. 3.

In this embodiment, the two central electrodes 20 and 21 are disposed and the terminating resistance film 41 is connected to the single I/O port P3, making it possible to reduce the numbers of the central electrodes, capacitors, and I/O terminal electrodes in comparison with the conventional isolator and thus to respond to the demand for a reduced size and a lower price. Accordingly, this embodiment is capable of providing the same advantage as that accomplished by the embodiment described above.

Moreover, unlike the two-terminal isolator disclosed in Japanese Unexamined Patent Publication No. 52-134349, this embodiment does not have any resistor connected to the I/O port P1; therefore, a potential difference, if any, between the I/O port P1 and the I/O port P2 would not cause a loss at the resistor. Accordingly, there will be no problem of the deterioration in the insertion loss characteristic.

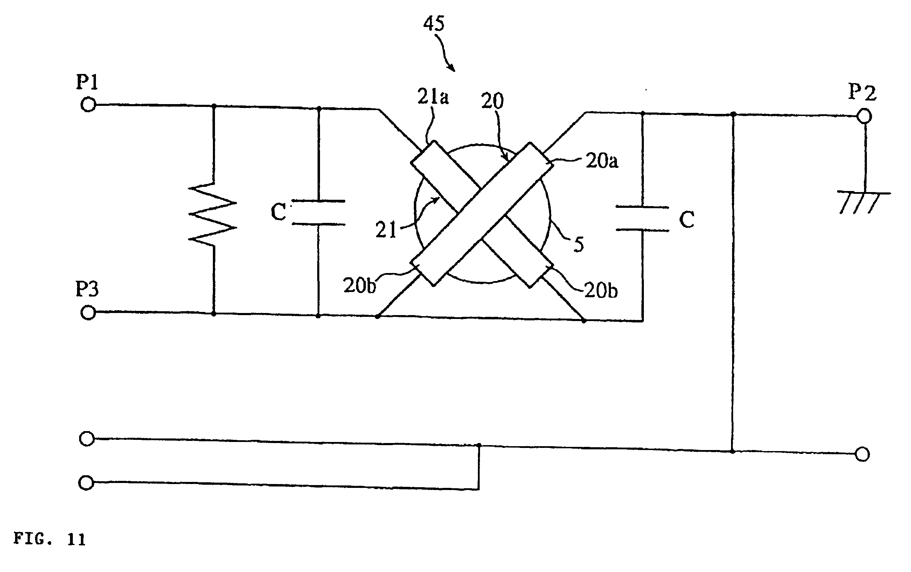

Fig. 11 is a diagram illustrative of an isolator in accordance with another embodiment of the present invention described in Claim 4. Like reference numerals in the drawing as those shown in Fig. 7 denote like or corresponding components. The isolator shares the same basic circuit configuration as that shown in Fig. 7; therefore, only different sections will be described.

The isolator 45 is constituted by connecting the single I/O port P2 to the ground and by connecting a resistor R of a resistance value, which is approximately equal to the terminal impedance, in parallel between the remaining I/O ports P1 and P3. In this embodiment, the resistor may alternatively be connected in parallel between the ports P2 and P3 and the port P1 may be grounded; or the resistor may be connected in parallel between the ports P1 and P2 and the port P3 may be grounded.

The operating principle of the isolator 45 will be described in conjunction with Fig. 11.

When a signal is supplied through P1, the currents flow from P1 to P3 via the resistor R. At this time, the currents do not flow from P1 to P3 via the central electrodes 21 and 20; therefore, no inductive electromotive force is generated between P2 and P3. Hence, P2 and P3 will be at nearly the same potential and the potential at P3 is always approximated to zero volt. Thus, the potential difference between P1 and P3 will be nearly equal to that between P1 and the ground, causing the signal, which has been entered through P1, to be absorbed by the resistor R.

As mentioned in the foregoing embodiment, when the circulator receives the signal through P3, the potential at P1 and P3 stays nearly the same at all times and the potential at P2 is always approximated to zero volt. Accordingly, even if the resistor is connected between P1 and P3, the potential at both ends of the resistor are always nearly the same and therefore, little current flows through the resistor. Further, whether P2 is short-circuited with the ground or not, the potential thereof will be approximated to zero volt at all times. Hence, this embodiment exhibits almost the same transmitting characteristic as that of the embodiments previously described; the signal applied to P3 is output to P1. Such an operation applies to other combinations of the ports.

In this embodiment, the resistor R is connected in parallel between the two I/O ports P1 and P3, making it possible to reduce the numbers of the central electrodes, capacitors, and I/O terminal electrodes in comparison with the conventional isolator and thus to respond to the demand for a reduced size and a lower price. Accordingly, this embodiment is capable of providing the same advantage as that accomplished by the embodiments described above. Moreover, this embodiment permits further reduced cost since it obviates the need of the GND electrodes in comparison with the isolators described above.

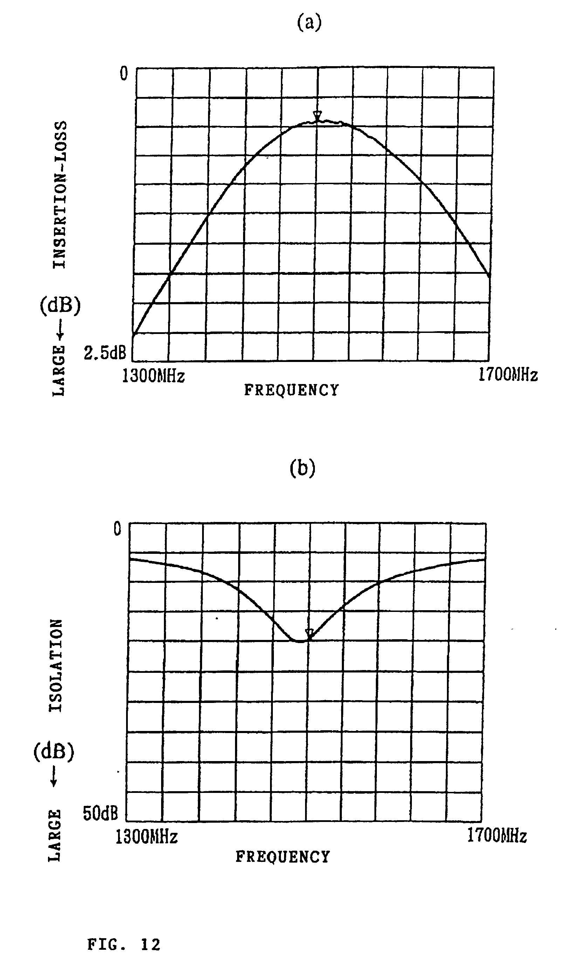

Fig. 12A shows the measurement result of the insertion loss characteristic of the isolator 45; and Fig. 12B shows the measurement result of the isolation characteristic. The measurement was performed by connecting a resistor of 50 ohms in parallel between the ports P1 and P3, and by short-circuiting the port P2 by grounding it. As it is obvious from the characteristic curves, the isolator 45 has exhibited satisfactory values in both characteristics.

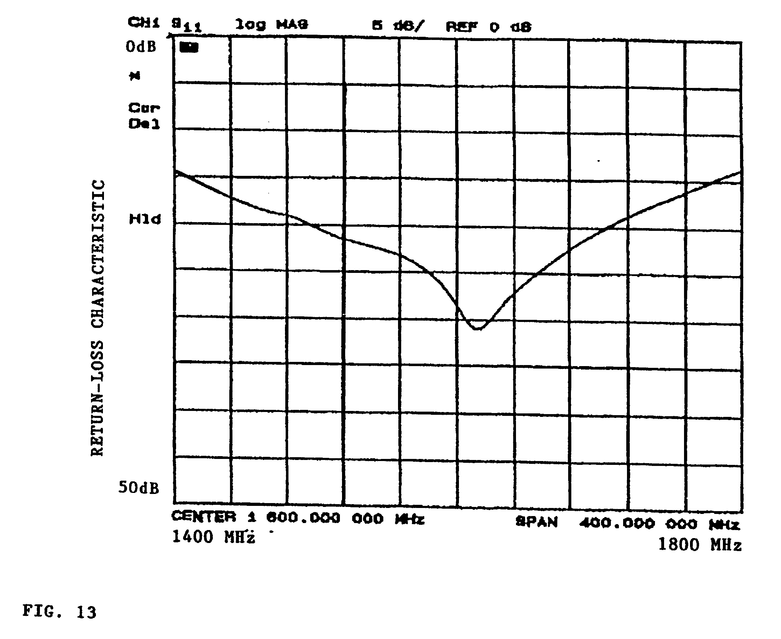

In this embodiment, since the resistors are connected to the I/O port P1 and the I/O port P3, the loss at the resistors takes place due to the potential difference between the I/O port P1 and the I/O port P3 as is the case with the two-terminal isolator disclosed in Japanese Unexamined Patent Publication No. 52-134349. This embodiment, however, provides a broader band of the return loss characteristic than that provided by the prior art disclosed in Japanese Unexamined Patent Publication No. 52-134349. More specifically, as shown in Fig. 13, the return loss characteristic value at 15 dB can be increased to 220 MHZ from about 100 MHZ which is obtained by the two-terminal isolator described in Japanese Unexamined Patent Publication No. 52-134349.

Thus, in the non-reciprocal circuit element in accordance with the present invention, the two central electrodes intersecting each other are disposed on the main surface of or in the ferrite member, the I/O ports are connected to the ends on one side of the two central electrodes and one I/O port is connected to the ends on the other side thereof. This permits a reduction in the numbers of the central electrodes, the capacitors, and the I/O terminal electrodes, offering an advantage of a reduced size and a lower price of the non-reciprocal circuit element constructed by the components.

In a preferred form according to the present invention, the matching circuit has been added by connecting a capacitor between the first and second I/O ports and the third I/O port, thus permitting easier matching with an external circuit.

In another preferred form according to the present invention, the terminating resistor is connected to any one of the I/O ports, thus providing an advantage of permitting a smaller and cheaper isolator.

Advantageously, the insertion loss characteristic is not deteriorated due to a potential difference between an input port and an output port. This advantage is not available with the two-terminal isolator described in Japanese Unexamined Patent Publication No. 52-134349.

In a still preferred form according to the present invention, any one of the I/O ports is connected to the ground, and the remaining two I/O ports are provided with the resistor which has a resistance value approximately equal to the impedance of the ports and which is connected in parallel between the two ports. This also provides an advantage of a smaller and cheaper isolator. There is also an advantage in that the isolator according to the present invention permits a broader band of the return loss characteristic.

In a further preferred form according to the present invention, the central electrodes are stacked alternately with the insulating sheets interleaved therebetween to form a laminated assembly. This configuration is advantageous for achieving higher density which permits a reduced size.

In another preferred form according to the present invention, the respective I/O port electrodes to which the respective central electrodes are connected are formed on the outer surface of the foregoing laminated assembly. This configuration advantageously permits a still higher density with a resultant further reduced size.

In a further preferred form according to the present invention, the insulating sheets are composed of ferrite to provide an advantage of enabling a still higher density of components mounted, with a resultant further reduced size.

## Claims

1. A non-reciprocal circuit element comprising:
a central electrode assembly composed of first and second central electrodes (20,21) which are disposed on a ferrite member (5) in such a manner that they intersect with each other while being electrically insulated from each other, said first and second electrodes (20,21) each having respective first and second ends,
first and second I/O ports (P1,P2) which are respectively connected to the first ends (20a,21a) of the first and second central electrodes (20,21), and a third I/O port (P3) which is connected in common to both of the second ends (20b,21b) of the first and second central electrodes (20,21); and
a magnetic circuit (3) for applying a DC magnetic field to said ferrite member (5);
**characterized by**
a matching circuit comprising respective capacitors connected between respective ones of said first and second I/O ports (P1,P2), and said third I/O port (P3).

2. A non-reciprocal circuit element according, to Claim 1, wherein a terminating resistor (41) is connected to any one of the I/O ports.

3. A non-reciprocal circuit element according to Claim 1 or 2, wherein either the first or second I/O port (P2) is grounded, and a resistance (R) which is approximately equal to a terminal impedance is connected in parallel between the remaining I/O port and the third I/O port (P1,P2).

4. A non-reciprocal circuit element according to any one of Claims 1 to 3, wherein said central electrode assembly is composed of insulating sheets (7 to 11) and central electrodes (20,21) which are laminated so that they are alternately stacked with the insulating sheets (7 to 11) interleaved between said central electrodes (20,21) to form a laminated body.

5. A non-reciprocal circuit element according to Claim 4, wherein respective I/O port electrodes (17,18, 19) to which the respective central electrodes (20,21) are connected are formed on the outer surface of said laminated body.

6. A non-reciprocal circuit element according to Claim 4 or 5, wherein said insulating sheets (7 to 11) are composed of ferrite.

## Patentansprüche

1. Ein nichtreziprokes Schaltungselement mit folgenden Merkmalen:
einem Mittelelektrodenaufbau, der aus einer ersten und einer zweiten Mittelelektrode (20, 21) gebildet ist, die auf eine derartige Weise auf einem Ferrit-Bauglied (5) angeordnet sind, daß sie einander schneiden, während sie elektrisch voneinander isoliert sind, wobei die erste und die zweite Elektrode (20, 21) jeweils ein erstes und ein zweites Ende aufweisen;
einem ersten und einem zweiten I/O-Tor (P1, P2), die jeweils mit dem ersten Ende (20a, 21a) der ersten und der zweiten Mittelelektrode (20, 21) verbunden sind, und einem dritten I/O-Tor (P3), das gemeinsam mit den zweiten Enden (20b, 21b) der ersten und der zweiten Mittelelektrode (20, 21) verbunden ist; und
einer Magnetschaltung (3) zum Anlegen eines Gleichmagnetfeldes an das Ferrit-Bauglied (5),
**gekennzeichnet durch**
eine Anpassungsschaltung, die jeweilige Kondensatoren aufweist, die zwischen jeweilige des ersten und des zweiten I/O-Tors (P1, P2) und das dritte I/O-Tor (P3) geschaltet sind.

2. Ein nichtreziprokes Schaltungselement gemäß Anspruch 1, bei dem ein Abschlußwiderstand (4) mit einem der I/O-Tore verbunden ist.

3. Ein nichtreziprokes Schaltungselement gemäß Anspruch 1 oder 2, bei dem entweder das erste oder das zweite I/O-Tor (P2) geerdet ist und ein Widerstand (R), der im wesentlichen gleich einer Abschlußimpedanz ist, parallel zwischen das verbleibende I/O-Tor und das dritte I/O-Tor (P1, P2) geschaltet ist.

4. Ein nichtreziprokes Schaltungselement gemäß einem der Ansprüche 1 bis 3, bei dem der Mittelelektrodenaufbau aus Isolierschichten (7 bis 11) und Mittelelektroden (20, 21) gebildet ist, die so laminiert sind, daß sie abwechselnd mit den Isolierschichten (7 bis 11) gestapelt sind, die zwischen den Mittelelektroden (20, 21) verschachtelt sind, um einen laminierten Körper zu bilden.

5. Ein nichtreziprokes Schaltungselement gemäß Anspruch 4, bei dem jeweilige I/O-Tor-Elektroden (17, 18, 19), mit denen die jeweiligen Mittelelektroden (20, 21) verbunden sind, an der äußeren Oberfläche des laminierten Körpers gebildet sind.

6. Ein nichtreziprokes Schaltungselement gemäß Anspruch 4 oder 5, bei dem die Isolierschichten (7 bis 11) aus Ferrit bestehen.

## Revendications

1. Elément de circuit non réciproque, comprenant :
un ensemble d'électrodes centrales composé de première et deuxième électrodes centrales (20, 21) qui sont disposées sur un élément de ferrite (5), de telle manière qu'elles se croisent l'une l'autre tout en étant électriquement isolées l'une de l'autre, lesdites première et deuxième électrodes (20, 21) ayant chacune des premières et deuxième extrémités respectives,
des premier et deuxième ports d'accès d'entrée-sortie, ou ports I/O, (P1, P2), qui sont respectivement connectés aux premières extrémités (20a, 21a) des première et deuxième électrodes centrales (20, 21), et un troisième port I/O (P3) qui est connecté en commun à l'une et l'autre des deuxièmes extrémités (20b, 21b) des première et deuxième électrodes centrales (20, 21) ; et
un circuit magnétique (3) permettant d'appliquer un champ magnétique continu audit élément de ferrite (5) ;
**caractérisé par** :
un circuit d'adaptation comprenant des condensateurs respectifs qui sont connectés entre les ports respectifs desdits premier et deuxième ports I/O (P1, P2), et ledit troisième port I/O (P3).

2. Elément de circuit non réciproque selon la revendication 1, où une résistance de terminaison (41) est connectée à l'un quelconque des port I/O.

3. Elément de circuit non réciproque selon la revendication 1 ou 2, où l'un ou l'autre des premier et deuxième ports I/O (P2) est connectés à la terre électrique, et une résistance (R), qui est approximativement égale à une impédance terminale, est connectée en parallèle entre le port I/O restant et le troisième port I/O (P1, P2).

4. Elément de circuit non réciproque selon l'une quelconque des revendications 1 à 3, où ledit ensemble d'électrodes centrales est composé de feuilles isolantes (7 à 11) et d'électrodes centrales (20, 21) qui sont stratifiées de façon qu'elles soient empilées, en alternance, avec les feuilles isolantes (7 à 11) entrelacées entre lesdites électrodes centrales (20, 21) pour former un corps stratifié.

5. Elément de circuit non réciproque selon la revendication 4, où des électrodes respectives (17, 18, 19) de ports I/O auxquelles les électrodes centrales respectives (20, 21) sont connectées sont formées sur la surface extérieure dudit corps stratifié.

6. Elément de circuit non réciproque selon la revendication 4 ou 5, où lesdites feuilles isolantes (7 à 11) sont composées de ferrite.
